# EUROPÄISCHE PATENTANMELDUNG

(11) **EP 0 920 117 A2**
(43) Veröffentlichungstag der Anmeldung: **02.06.1999**
(21) Anmeldenummer: 98120814.3
(22) Anmeldetag: 03.11.1998
(51) Int. Cl.: H02M 7/48

(54) **Phasenregelumgseinrichtung für den Wechselrichter eines Schwingkreises**

(30) Priorität: 21.11.1997 DE 19751666
(71) Anmelder: ELOTHERM GmbH, D-42855 Remscheid (DE)
(72) Erfinder: Busch, Bernd, 42859 Remscheid (DE); Zok, Edmund, 42897 Remscheid (DE); Reifenrath, Klaus, 42657 Solingen (DE)
(74) Vertreter: Cohausz & Florack

(57) **Zusammenfassung**

Die Erfindung betrifft eine Phasenregelungseinrichtung für einen Wechselrichter (WR), welcher zur Energieversorgung eines Schwingkreises (RSK) eingesetzt ist, mit einem von einem Phasendiskriminator (PD) angesteuerten, den Wechselrichter (WR) mittels Steuerimpulsen (P_{VCO}) steuernden spannungsgesteuerten Oszillator (VCO), wobei der Phasendiskriminator (PD) in Abhängigkeit von der Phasenverschiebung eines mit der Wechselrichterausgangsspannung phasengleichen Signals und eines mit dem Wechselrichterausgangsstrom phasengleichen Signals die Frequenz der von dem Oszillator (VCO) abgegebenen Steuerimpulse (P_{VCO}) derart steuert, daß die Ausgangsspannung und der Ausgangsstrom des Wechselrichters (WR) in Phase sind. Um bei einer derartigen Einrichtung die Ansteuerung eines Reihenschwingkreises durch einen Wechselrichter bei geringen Leistungsverlusten zu ermöglichen, ist bei der erfindungsgemäßen Phasenregelungseinrichtung vorgesehen, daß der Schwingkreis ein Reihenschwingkreis (RSK) ist und daß als der Ausgangsspannung des Wechselrichters (WR) phasengleiches Signal die von dem Oszillators (VCO) ausgegebenen Impulse (P_{VCO}) über eine Zeitverzögerungseinheit (TV) an den Phasendiskriminator (PD) geliefert werden.

## Beschreibung

Die Erfindung betrifft eine Phasenregelungseinrichtung für einen Wechselrichter, welcher zur Energieversorgung eines Schwingkreises eingesetzt ist, mit einem von einem Phasendiskriminator angesteuerten, den Wechselrichter mittels Steuerimpulsen steuernden spannungsgesteuerten Oszillator, wobei der Phasendiskriminator in Abhängigkeit von der Phasenverschiebung eines mit der Wechselrichterausgangsspannung phasengleichen Signals und eines mit dem Wechselrichterausgangsstrom phasengleichen Signals die Frequenz der von dem Oszillator abgegebenen Steuerimpulse derart steuert, daß die Ausgangsspannung und der Ausgangsstrom des Wechselrichters in Phase sind.

Eine Phasenregelungseinrichtung für den Wechselrichter eines Schwingkreises ist aus der deutschen Offenlegungsschrift DE 34 41 001 A1 bekannt. Nach dieser Druckschrift wird zur Beseitigung der Blindleistung bei einem Schwingkreis, der von einer Induktionsspule und einem Kondensator gebildet wird, Strom und Spannung des Schwingkreises erfaßt und die Stromversorgungsquelle des Schwingkreises über die ermittelte Phasenverschiebung von Strom und Spannung gesteuert. Bei Auftreten einer Phasenverschiebung wird durch Änderung der Frequenz der Stromversorgungsquelle die Phasenverschiebung reduziert.

In der Praxis hat sich gezeigt, daß bei einer solchen Einrichtung Probleme auftreten können. Die erfaßten und dem Phasendiskriminator gelieferten "echten" Istwerte von Strom und Spannung, aus denen die Phasendifferenz zwischen Wechselrichterausgangsstrom und Wechselrichterausgangsspannung bestimmt wird, sind in der Regel fehlerbehaftet. Je nach der Ordnung der mathematischer Funktion des Regelungssystems ist bei der weiteren Verarbeitung dieser beiden Meßwerte bestenfalls eine Multiplizierung, schlechtestenfalls eine Potenzierung der Istwertfehler zu erreichen. Daher kann es zu Instabilitäten im Schwingkreis kommen, die in einer Systemabschaltung gipfeln können.

Die deutsche Patentschrift DE 36 01 191 C1 beschreibt eine Phasenregeleinrichtung zur Steuerung eines Parallelschwingkreisumrichters, mit der derartige Probleme vermieden werden. Die Steuerung dieser Einrichtung beruht ebenfalls auf dem Prinzip einer Steuerung des Umrichters über einen Oszillator, dessen Ausgangsfrequenz über eine Phasenvergleichsstufe so geregelt wird, daß Wechselrichterausgangsspannung und Wechselrichterausgangsstrom in Phase sind. Bei dieser Einrichtung wird einerseits die Wechselrichterausgangsspannung gemessen und einer Phasenvergleichsstufe zugeführt wird. Im Gegensatz zu der aus der DE 34 41 001 A1 bekannten Einrichtung liefert andererseits aber ein Signalgeber, der über die Ausgangsimpulse des Oszillators angesteuert wird, gegenüber diesen Signalen zeitverzögerte Impulse als zweite Signale an Stelle eines erfaßten Wechselrichterausgangsstroms an die Phasenvergleichsstufe. Die Zeitverzögerung ist dabei entsprechend der Lauf- und Einschaltzeiten der Bauelemente der Schaltung vorgegeben.

Für einen Parallelschwingkreis werden mit der in der DE 36 01 191 C1 vorgeschlagenen Einrichtung die Probleme, die sich beim Einsatz der Phasenregelungseinrichtung der DE 34 41 001 A1 ergeben können, vermieden. Wird mit einer derartigen Einrichtung jedoch ein Reihenschwingkreis angesteuert, so treten weiterhin Probleme auf.

Der Erfindung liegt die Aufgabe zugrunde, eine Einrichtung der eingangs genannten Art zu schaffen, welche bei geringen Leistungsverlusten die Ansteuerung eines Reihenschwingkreises durch einen Wechselrichter ermöglicht.

Diese Aufgabe wird erfindungsgemäß dadurch gelöst, daß der Schwingkreis ein Reihenschwingkreis ist und daß als der Ausgangsspannung des Wechselrichters phasengleiches Signal die von dem Oszillators ausgegebenen Impulse über eine Zeitverzögerungseinheit an den Phasendiskriminator geliefert werden.

Die Erfindung sieht vor, daß die von dem spannungsgesteuerten Oszillators ausgegebenen Steuerimpulse nicht nur zur Ansteuerung des Wechselrichters verwendet werden, sondern daß sie gleichzeitig einer Zeitverzögerungseinheit zugeführt werden. Die Zeitverzögerungseinheit verzögert die Impulse so, daß das sich ergebende Signal mit der Wechselrichterausgangsspannung phasengleich ist. Anschließend liefert die Zeitverzögerungseinheit dieses Signal als ein Eingangssignal an den Phasendiskriminator.

Durch die erfindungsgemäße Phasenregelungseinrichtung wird es ermöglicht, dem Phasendiskriminator nur einen Istwert zur Verfügung zu stellen und damit Probleme zu vermeiden, die aufgrund von Istwertfehlern auftreten können.

Hinzu kommt, daß mit der Einrichtung Schwierigkeiten bei der Erfassung der Phasenlage der Wechselrichterausgangsspannung vermieden werden. Wird bei einem Reihenschwingkreis zur Steuerung des Wechselrichters dem Phasendiskriminator direkt die Ausgangsspannung des Wechselrichters als der Wechselrichterspannung phasengleiches Signal zugeführt, so besteht die Gefahr, daß die Nulldurchgänge des Spannungsistwertes je nach Betriebszustand des Umrichters nicht richtig zu detektieren sind. In diesem Fall kann der Phasendiskriminator die aktuelle Phasendifferenz zwischen Wechselrichterstrom und Wechselrichterspannung nicht genau erfassen und damit auch den Oszillator nicht korrekt steuern. Da die Wechselrichterausgangsspannung aber erfindungsgemäß synthetisch generiert wird, wird dieses Problem umgangen.

Für eine variable Einsatzmöglichkeit der Phasenregelungseinrichtung ist vorgesehen, daß die verwendete Zeitverzögerungseinheit einstellbar ist.

Nach einer bevorzugten Ausführungsform der Erfindung ist die Zeitverzögerungseinheit programmierbar. Hierdurch wird ein besonders flexibler und genau einstellbarer Einsatz der Zeitverzögerungseinheit ermöglicht.

Nachfolgend wird die Erfindung anhand einer ein Ausführungsbeispiel darstellenden Zeichnung näher erläutert.

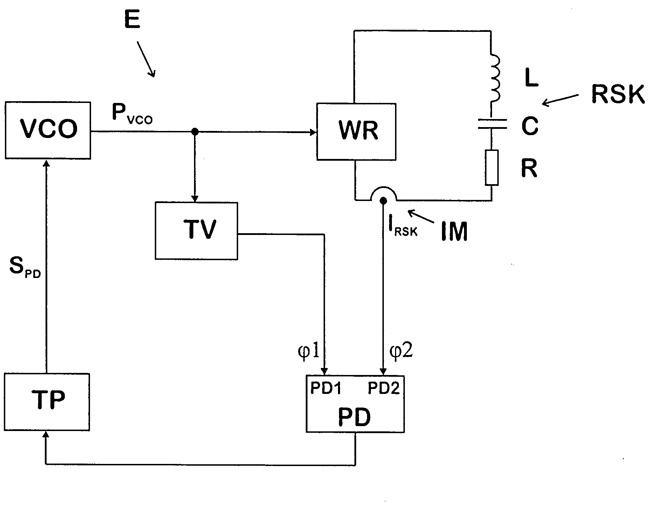

Die einzige Figur zeigt in einem Blockschaltbild eine Phasenregeleinrichtung E, die einen Wechselrichter WR steuert. Der Wechselrichter WR versorgt einen Reihenschwingkreis RSK mit Energie.

Der Reihenschwingkreis ist durch Reihenschaltung einer Induktivität L, einer Kapazität C und eines Widerstandes R gebildet und durch den Wechselrichter WR geschlossen. An der Verbindung zwischen dem Widerstand R und dem Wechselrichter WR ist eine Strommesseinheit IM vorgesehen, welche den durch den Reihenschwingkreis RSK fließenden Strom I_{RSK} erfaßt.

Die Phasenregeleinrichtung E für den Wechselrichter WR umfaßt einen spannungsgesteuerten Oszillator VCO, dessen Ausgang einerseits mit dem Steuereingang des Wechselrichters WR und andererseits mit dem Signaleingang einer programmierbaren Zeitverzögerungseinrichtung TV verbunden ist. An den Ausgang der Zeitverzögerungseinrichtung TV ist der erste Signaleingang PD1 eines Phasendiskriminators PD angeschlossen. An den zweiten Signaleingang PD2 ist der Signalausgang der Strommeßeinheit IM gelegt. Der Ausgang des Phasendiskriminators PD ist über ein Tiefpassfilter TP mit dem Steuersignaleingang des Oszillators VCO verbunden.

Der Oszillator VCO liefert Steuerimpulse P_{VCO} an den Wechselrichter WR und die Zeitverzögerungseinheit TV, deren Frequenz von der am Steuereingang des Oszillators VCO anliegenden Steuerspannung S_{PD} abhängen. Der durch die Impulse P_{VCO} angesteuerte Wechselrichter WR versorgt den Reihenschwingkreis RSK mit einer Wechselspannung, deren Frequenz in direktem Bezug zu der Frequenz der Impulse P_{VCO} steht. Durch eine Variation der Frequenz der Impulse P_{VCO} wird die Phasendifferenz zwischen dem Ausgangsstrom und der Ausgangsspannung des Wechselrichters WR geregelt.

Die Zeitverzögerungseinheit TV liefert an den ersten Eingang PD1 des Phasendiskriminators PD ein zu der Ausgangsspannung des Wechselrichters WR phasengleiches Eingangssignal ϕ1. Dazu werden von ihr die Steuerimpulse P_{VCO} des Oszillators VCO um die Zeitspanne verzögert, die den Lauf- und Einschaltzeiten der einzelnen Bauelemente der Schaltung entsprechen. Durch eine entsprechende Programmierung der Zeitverzögerungseinheit TV ist die Zeitspanne einstellbar, um welche die Steuerimpulse P_{VCO} verzögert werden.

Das am Signaleingang PD2 anliegende, mit dem Ausgangsstrom des Wechselrichters WR phasengleiche zweite Eingangssignal ϕ2 wird durch den von der Strommeßeinheit IM gemessenen Strom I_{RSK} gebildet.

Der Phasendiskriminator PD bestimmt aus seinen Eingangssignalen j1,j2 die Phasendifferenz und gibt als Steuergröße für den Oszillator VCO die der Phasendifferenz entsprechende, über das Tiefpassfilter TP zusätzlich gefilterte Steuerspannung S_{PD} aus. Entsprechend einer mit einer Veränderung der Phasendifferenz einhergehenden Änderung dieser Steuerspannung S_{PD} ändert sich die Frequenz der von dem Oszillator VCO abgegebenen Steuerimpulse P_{VCO}.

## Patentansprüche

1. Phasenregelungseinrichtung für einen Wechselrichter (WR), welcher zur Energieversorgung eines Schwingkreises (RSK) eingesetzt ist, mit einem von einem Phasendiskriminator (PD) angesteuerten, den Wechselrichter (WR) mittels Steuerimpulsen (P_{VCO}) steuernden spannungsgesteuerten Oszillator (VCO), wobei der Phasendiskriminator (PD) in Abhängigkeit von der Phasenverschiebung eines mit der Wechselrichterausgangsspannung phasengleichen Signals und eines mit dem Wechselrichterausgangsstrom phasengleichen Signals die Frequenz der von dem Oszillator (VCO) abgegebenen Steuerimpulse (P_{VCO}) derart steuert, daß die Ausgangsspannung und der Ausgangsstrom des Wechselrichters (WR) in Phase sind,
**dadurch gekennzeichnet,**
- daß der Schwingkreis ein Reihenschwingkreis (RSK) ist und
- daß als der Ausgangsspannung des Wechselrichters (WR) phasengleiches Signal die von dem Oszillators (VCO) ausgegebenen Impulse (P_{VCO}) über eine Zeitverzögerungseinheit (TV) an den Phasendiskriminator (PD) geliefert werden.

2. Phasenregelungseinrichtung nach Anspruch 1,
**dadurch gekennzeichnet,** daß die Zeitverzögerungseinheit (TV) einstellbar ist.

3. Phasenregelungseinrichtung nach Anspruch 2,
**dadurch gekennzeichnet,** daß die Zeitverzögerungseinheit (TV) programmierbar ist.
